Europäisches Patentamt

European Patent Office

Office européen des brevets

(11) Publication number: 0 653 685 A1

# EUROPEAN PATENT APPLICATION

(21) Application number: 94203043.8

(51) Int. Cl.6: G03F 7/34, G03F 7/11

(22) Date of filing: 20.10.94

(30) Priority: 16.11.93 EP 93203186

(43) Date of publication of application:
17.05.95 Bulletin 95/20

(84) Designated Contracting States:
BE DE FR GB NL

(71) Applicant: AGFA-GEVAERT naamloze
vennootschap
Septestraat 27
B-2640 Mortsel (BE)

(72) Inventor: Vermeersch, Joan, c/o Agfa-Gevaert
N.V.
DIE 3800,
Septestraat 27
B-2640 Mortsel (BE)
Inventor: Daems, Eddie, c/o Agfa-Gevaert N.V.
DIE 3800,
Septestraat 27
B-2640 Mortsel (BE)
Inventor: Van Damme, Marc, c/o Agfa-Gevaert
N.V.
DIE 3800,
Septestraat 27
B-2640 Mortsel (BE)
Inventor: Leenders, Luc, c/o Agfa-Gevaert
N.V.
DIE 3800,
Septestraat 27
B-2640 Mortsel (BE)
Inventor: Nouwen, Tom, c/o Agfa-Gevaert N.V.
DIE 3800,
Septestraat 27
B-2640 Mortsel (BE)
Inventor: Uytterhoeven, Herman, c/o
Agfa-Gevaert N.V.
DIE 3800,
Septestraat 27
B-2640 Mortsel (BE)
Inventor: Hendrikx, Peter, c/o Agfa-Gevaert
N.V.
DIE 3800,
Septestraat 27
B-2640 Mortsel (BE)

(54) Methods for producing lithographic plates with imaging elements comprising a photopolymerizable composition.

(57) The present invention provides a method for obtaining a lithographic printing plate comprising the steps of:
(a) image-wise or information-wise exposing an imaging element comprising on a hydrophilic base a hydrophobic photopolymerizable composition capable of being irradiated with actinic light through the support and/or through the front and comprising at least one monomer and at least one polymeric binder, said photopolymerizable composition comprising the top layer of said imaging element or the layer contiguous to a temporary protective layer (packet) being the top layer (packet) of said imaging element,
(b) laminating the hydrophobic photopolymerizable composition of said imaging element after said exposure and the removal of the temporary layer (packet), if present, to the receptor layer of a receptor element, said receptor layer being capable of adhering to said hydrophobic photopolymerizable composition and being a pressure-adhesive layer, a thermoadhesive layer, having a glas transition temperature $T_g$ between 10 °C and 100 °C as measured with the 1090 THERMOANALYZER of Du Pont Co. and a melt viscosity of more than 3000 Poise measured at 120 °C with the VISCOELASTIC MELT TESTER of Rheometrics Co, Surrey, UK. or paper or a poly-Alpha-olefin coated paper.
(c) peeling away the receptor element from the hydrophilic base thus transferring said hydrophobic photopolymerizable composition pattern-wise to the receptor element.

1. Field of the invention.

The present invention relates to a method for obtaining lithographic printing plates from imaging elements comprising a photopolymerisable composition.

2. Background of the invention.

The use of photosensitive imaging elements comprising photopolymerizable compositions for the production of images by information-wise exposure thereof to actinic radiation is well known. Several methods for forming images using photopolymerizable compositions are known. All these methods are based on the principle of introducing a differentiation in properties between the exposed and non-exposed parts of the photopolymerizable composition e.g. a difference in solubility, adhesion, conductivity, refractive index, tackiness, permeability, diffusibility of incorporated substances e.g. dyes etc.. The thus produced differences may be subsequently employed in a developing step to produce a visible image and/or master for printing e.g. a lithographic or electrostatic printing master.

A difference in solubility between the exposed and non-exposed parts of the photopolymerizable composition is often used for the production of lithographic printing plates where a hydrophilic base is coated with the photopolymerizable composition, subsequently exposed and developed using a solvent to remove the non-exposed or insufficiently exposed parts. Such a process is for example described in "Unconventional imaging processes" by E. Brinckman, G. Delzenne, A. Poot and J. Willems, Focal Press London-New York, first edition 1978, pages 33 to 39 and in GB-P 1,419,512.

The use of the difference in tackiness to obtain an image is described in e.g. US-P 3,060,024, 3,085,488 and 3,649,268. According to the method disclosed in these US patents the image-wise exposed photopolymerizable composition looses its tackiness in the exposed parts while the non-exposed parts keep their tackiness. The non-exposed parts can therefore be colored with dry dye pigments to make the image visible.

According to a method disclosed in US-P 3,060,023 the adhesion of the photopolymerizable composition is modified upon image-wise exposure. After image-wise exposure the non-exposed parts will stick or adhere, during a step of overall heating, to an image receiving means thus allowing the transfer of the non-exposed parts to the image receiving means.

UD-P 3,307,943 discloses a process for image production which comprises (i) exposing imagewise a photopolymerizable element to provide a difference of at least 10° C in the stick temperature of said exposed and underexposed areas, (ii) transferring said image corresponding to the underexposed areas by bringing the surface of the exposed element into operative contact with the surface of an image-receptive support at an operating temperature intermediate between the stick temperature of said exposed and underexposed areas, (iii) subsequently separating the two surfaces at a temperature intermediate between the stick temperatures of the exposed and underexposed image areas and (iv) exposing a radiation-sensitive element by means of radiation embodying ultraviolet rays through the element containing the transferred image.

US-P 3,342,593 discloses a process for image production which comprises (i) exposing a photopolymerizable element having a stick temperature above 40°C and below 220°C imagewise, said photopolymerizable element having a support bearing a photopolymerizable layer comprising (1) an compound containing at least one terminal ethylenic group, (2) an initiator, (ii) preheating said exposed element to a temperature above 35°C but below the stick temperature of the underexposed areas, (iii) heating said exposed element to a temperature above said stick temperature and (iv) transferring the unexposed polymer to a receptor.

US-P 3,622,320 discloses imaging elements containing photocrosslinkable polyesters for use in heat transfer processes for making images or for making a lithographic printing plate.

GB-P 1,530,410 discloses a light-sensitive planographic printing plate material comprising (a) a support the surface of which is anodically oxidized aluminium or aluminium alloy, (b) a layer consisting of a hydrophillic organic polymer, (c) at least one layer of a light-sensitive composition and (d) a transparent cover film, arranged on said oxidized surface of the support in this order, the light-sensitive composition having the property that after the material has been imagewise exposed to light there is a difference in the adhesivity to polymer layer (b) and said transparent cover film between exposed areas and unexposed areas of said light-sensitive composition (c), the areas of greater adhesivity to said transparent cover film of said light-sensitive composition layer are peeled off together with said transparent cover film and the areas of greater adhesivity to said polymer layer (b) are left thereon, whereby an image is formed supported on the support.

2

EP 0 653 685 A1

EP-A 40,424 discloses a negative-working dry peel apart photopolymerizable element consisting essentially of a support, a cover sheet and therebetween a layer of photopolymerizable composition consisting essentially of (1) at least two halogen-free polymeric organic binders, (2) an initiator system, and (3) a monomer having at least one terminal ethylenic group, the monomer being present in a quantity in excess of the absorptive capacity of the binders for the monomer so that a thin layer of substantially free monomer is present at the interface between the photopolymerizable layer and the cover sheet, the adhesion of the polymerizable layer to the cover sheet being greater before polymerization than it is to the support.

EP-A 568,744 discloses a method for producing a lithographic printing plate which comprises: (i) providing an uncoated lithographic substrate, (ii) coating a photosensitive layer on one side of the lithographic substrate, (iii) providing a flexible substrate, (iv) coating an adhesive layer directly on the flexible substrate, (v) laminating the coated lithographic substrate to the coated flexible substrate, (vi) imagewise exposing the laminated element of (v) to radiation to which the photosensitive layer is sensitive and (vii) peeling off the flexible substrate along with the nonimage areas of the photosensitive layer.

Photosensitive imaging elements comprising photopolymerizable compositions can be used for the production of lithographic plates when information-wise exposure to actinic radiation and if necessary development of said photosensitive imaging elements will result in an image-wise differentiation between hydrophilic and hydrophobic parts that can be used to print with an oily or greasy ink. The hydrophobic parts will be capable of accepting lithographic ink, whereas the hydrophilic areas, when moistened with water, will not accept the ink.

As illustrated above photopolymerization can be used in a variety of methods to produce lithographic printing plates. Among these methods several are using dry-developing steps for producing lithographic printing plates which is convenient and offers an ecological advantage. However the quality of the copies obtainable with such lithographic printing plates using a dry-developing step, e.g. a thermal transfer step, is rather low due to staining (ink acceptance in the non-printing areas). Furthermore a method for producing a lithographic plate using a dry-developing step and wherein the imaging element being the precursor of the lithographic plate comprises a commercial and/or easy to prepare photosensitive composition is still desirable, being more convenient and offering economical and ecological advantages.

3. Summary of the invention.

It is an object of the present invention to provide a method for obtaining a lithographic printing plate of a high quality using an imaging element comprising a photopolymerisable composition on a hydrophilic base by a dry-developing step.

It is another object of the present invention to provide a method for obtaining a lithographic printing plate in a convenient way, offering economical and ecological advantages.

It is still another object of the present invention to provide a method for obtaining a lithographic printing plate wherein said imaging element is the precursor of the lithographic plate.

Further objects of the present invention will become clear from the description hereinafter.

According to the present invention there is provided a method for obtaining a lithographic printing plate comprising the steps of:

(a) image-wise or information-wise exposing an imaging element comprising on a hydrophilic base a hydrophobic photopolymerizable composition capable of being irradiated with actinic light through the support and/or through the front and comprising at least one monomer and at least one polymeric binder, said photopolymerizable composition comprising the top layer of said imaging element or the layer contiguous to a temporary protective layer (packet) being the top layer (packet) of said imaging element,

(b) laminating the hydrophobic photopolymerizable composition of said imaging element after said exposure and the removal of the temporary player (packet), if present, to the receptor layer of a receptor element, said receptor layer being capable of adhering to said hydrophobic photopolymerizable composition and being a pressure-adhesive layer, a thermoadhesive layer, having a glas transition temperature $T_g$ between 1O °C and 100 °C as measured with the 1090 THERMOANALYZER of Du Pont Co. and a melt viscosity of more than 3000 Poise measured at 120 °C with the VISCOELASTIC MELT TESTER of Rheometrics Co, Surrey, UK. or paper or a poly-Alpha-olefin coated paper.

(c) peeling away the receptor element from the hydrophilic base thus transferring said hydrophobic photopolymerizable composition pattern-wise to the receptor element.

3

4. Detailed description of the invention.

It has been found that lithographic printing plates can be obtained according to the method of the present invention using an imaging element comprising on a hydrophilic base a hydrophobic photopolymerizable composition by using a dry-developing step. More precisely it has been found that said printing plates are of high quality and are provided in a convenient way, thereby offering economical and ecological advantages.

The hydrophilic base of the imaging element according to the present invention is a hydrophilic base that is stable at the processing conditions.

Said hydrophilic base may be a hydrophilic metallic support e.g. an aluminium support.

The aluminum support of the imaging element for use in accordance with the present invention can be made of pure aluminum or of an aluminum alloy, the aluminum content of which is at least 95%. The thickness of the support usually ranges from about 0.13 to about 0.50 mm.

The preparation of aluminum or aluminum alloy foils for lithographic offset printing comprises the following steps : graining, anodizing, and optionally sealing of the foil.

Graining and anodization of the foil are necessary to obtain a lithographic printing plate that allows to produce high-quality prints in accordance with the present invention. Sealing is not necessary but may still improve the printing results. Preferably the aluminum foil has a roughness with a CLA value between 0.2 and 1.5 $\mu$m, an anodization layer with a thickness between 0.4 and 2.0 $\mu$m and is sealed with an aqueous bicarbonate solution.

According to the present invention the roughening of the aluminum foil can be performed according to the methods well known in the prior art. The surface of the aluminum substrate can be roughened either by mechanical, chemical or electrochemical graining or by a combination of these to obtain a satisfactory adhesiveness of a silver halide emulsion layer to the aluminum support and to provide a good water retention property to the areas that will form the non-printing areas on the plate surface.

The electrochemical graining process is preferred because it can form a uniform surface roughness having a large average surface area with a very fine and even grain which is commonly desired when used for lithographic printing plates.

Electrochemical graining can be conducted in a hydrochloric and/or nitric acid containing electrolyte solution using an alternating or direct current. Other aqueous solutions that can be used in the electrochemical graining are e.g. acids like HCl, $HNO_3$, $H_2SO_2$, $H_3PO_4$, that if desired, contain additionally one or more corrosion inhibitors such as $Al(NO_3)_3$, $AlCl_3$, boric acid, chromic acid, sulfates, chlorides, nitrates, monoamines, diamines, aldehydes, phosphates, $H_2O_2$, etc. ...

Electrochemical graining in connection with the present invention can be performed using single-phase and three-phase alternating current. The voltage applied to the aluminum plate is preferably 10-35 V. A current density of 3-150 Amp/dm$^2$ is employed for 5-240 seconds. The temperature of the electrolytic graining solution may vary from 5-50°C. Electrochemical graining is carried out preferably with an alternating current from 10 Hz to 300 Hz.

The roughening is preferably preceded by a degreasing treatment mainly for removing fetty substances from the surface of the aluminum foil.

Therefore the aluminum foil may be subjected to a degreasing treatment with a surfactant and/or an aqueous alkaline solution.

Preferably roughening is followed by a chemical etching step using an aqueous solution containing an acid. The chemical etching is preferably carried out at a temperature of at least 30°C more preferably at least 40°C and most preferably at least 50°C.

Suitable acids for use in the aqueous etch solution are preferably inorganic acids and most preferably strong acids. The total amount of acid in the aqueous etch solution is preferably at least 150g/l. The duration of chemical etching is preferably between 3s and 5min.

After roughening and optional chemical etching the aluminum foil is anodized which may be carried out as follows.

An electric current is passed through the grained aluminum foil immersed as an anode in a solution containing sulfuric acid, phosphoric acid, oxalic acid, chromic acid or organic acids such as sulfamic, benzosulfonic acid, etc. or mixtures thereof. An electrolyte concentration from 1 to 70 % by weight can be used within a temperature range from 0-70°C. The anodic current density may vary from 1-50 A/dm$^2$ and a voltage within the range 1-100 V to obtain an anodized film weight of 1-8 g/m$^2$ $Al_2O_3.H_2O$. The anodized aluminum foil may subsequently be rinsed with demineralised water within a temperature range of 10-80°C.

After the anodizing step sealing may be applied to the anodic surface. Sealing of the pores of the aluminum oxide layer formed by anodization is a technique known to those skilled in the art of aluminum anodization. This technique has been described in e.g. the "Belgisch-Nederlands tijdschrift voor Oppervlaktetechnieken van materialen", 24ste jaargang/januari 1980, under the title "Sealing-kwaliteit en sealing-controle van geanodiseerd Aluminum". Different types of sealing of the porous anodized aluminum surface exist.

Preferably, said sealing is performed by treating a grained and anodized aluminum support with an aqueous solution containing a bicarbonate as disclosed in EP-A 567178, which therefor is incorporated herein by reference.

Preferably each of the above described steps is separated by a rinsing step to avoid contamination of the liquid used in a particular step with that of the preceding step.

To promote the image sharpness and, as a consequence thereof, the sharpness of the final printed copy, the anodization layer may be coloured in the mass with an antihalation dye or pigment e.g. as described in JA-Pu-58-14,797.

More preferably, said hydrophilic base is a hydrophilic base comprising a hardened hydrophilic layer, containing a hydrophilic binder and a hardening agent coated on a flexible support.

Such hydrophilic binders are disclosed in e.g. EP-A 450,199, which therefor is incorporated herein by reference. Preferred hardened hydrophilic layers comprise partially modified dextrans or pullulan hardened with an aldehyde as disclosed in e.g. EP-A 514,990 which therefor is incorporated herein by reference. More preferred hydrophilic layers are layers of polyvinyl alcohol hardened with a tetraalkyl orthosilicate and preferably containing $SiO_2$ and/or $TiO_2$ wherein the weight ratio between said polyvinylalcohol and said tetraalkyl orthosilicate is between 0.5 and 5 as disclosed in e.g. GB-P 1,419,512, FR-P 2,300,354, US-P-3,971,660, US-P 4,284,705, EP-A 405,016 and EP-A 450,199 which therefor are incorporated herein by reference.

A particularly suitable hydrophilic layer is a layer of polyvinyl alcohol hardened with tetramethylor-thosilicate or tetraethylorthosilicate containing $TiO_2$, wherein the weight ratio between said polyvinylalcohol and said tetramethylorthosilicate or tetraethylorthosilicate is between 0.8 and 2 and wherein the weight ratio between said polyvinylalcohol and said titaniumdioxide is preferably not higher than 1.

The flexible supports may be opaque or transparent, e.g. a paper support or a resin support. When a paper support is used preference is given to one coated at one or both sides with an Alpha-olefin polymer, e.g. a polyethylene layer which optionally contains an anti-halation dye or pigment. Preferably an organic resin support is used e.g. cellulose esters such as cellulose acetate, cellulose propionate and cellulose butyrate; polyesters such as poly(ethylene terephthalate); polyvinyl acetals, polystyrene, polycarbonate; polyvinylchloride or poly-Alpha-olefins such as polyethylene or polypropylene.

One or more subbing layers may be coated between the flexible hydrophobic support and the hydrophilic layer for use in accordance with the present invention in order to get an improved adhesion between these two layers.

A preferred subbing layer for use in connection with the present invention, is a subbing layer which is contiguous to the hydrophilic layer and contains gelatin and-silica.

According to the present invention the imaging element comprises on the hydrophilic base a hydrophobic photopolymerizable composition comprising at least one monomer and at least one polymeric binder. When the hydrophilic base comprises a hardened hydrophilic layer, said hydrophobic photopolymerizable composition is preferably contiguous to said hydrophilic base.

The at least one monomer comprised in said photopolymerizable composition can be a monomer having at least one polymerizable ethylenically unsaturated group. Monomers containing at least two polymerizable ethylenically unsaturated groups are preferably used. Particularly preferred are urethane type monomers, such as the compounds of table I and those disclosed in EP-A 502562 and unsaturated esters of polyols, especially esters of polyols and an alpha-methylene carboxylic acid.

Examples of urethane type monomers are given in table I.

## Table I

1.

$$(CH_2=C-COOCH_2)_2CH-OOCNH-(CH_2)_6-N \\ | \\ CH_3$$

2.

$$C_2H_5-C[CH_2O-CO-NH-(CH_2)_6-NH-COO-CH(CH_2-O-CO-C=CH_2)_2]_3 \\ | \\ CH_3$$

3.

$$C[CH_2O-CO-NH-(CH_2)_6-NH-COO-CH(CH_2-O-CO-C=CH_2)_2]_4 \\ | \\ CH_3$$

4.

5.

Examples of esters of a polyol and an alpha-methylene carboxylic acid are: ethylene diacrylate, glycerol tri(meth)acrylate, ethylene dimethacrylate, 1,3-propanediol di(meth)acrylate, 1,2,4-butanetriol tri(meth)-acrylate, 1,4-cyclohexanediol di(meth)acrylate, 1,4-benzenediol di(meth)acrylate, pentaerythritol tetra(meth)-acrylate, dipentaerythritol pentaacrylate, 1,5-pentanediol di(meth)acrylate, the bis acrylates and methacrylates of polyethylene glycols of molecular weight 200-500, and the like.

Other types of monomers suitable for use in the photopolymerizable composition in accordance with the present invention are e.g. the monomers disclosed in EP-A 502562, DEOS no. 4,109,239, 4,005,231, 3,643,216, 3,625,203, 3,516,257, 3,516,256 and 3,632,657, which therefor are incorporated herein by reference. Further types of monomers suitable for use in the photopolymerizable composition in accordance with the present invention are disclosed in EP-A 522,616. It will be clear that these monomers can be used in admixture.

In general, the photopolymerizable composition used in accordance with the present invention also comprises at least one photoinitiator, wich can be a single compound or a composition. Preferably used photoinitiators are polymerization initiators activatable by actinic light and inactive at and below the storing conditions of the photosensitive material. Examples of such initiators are disclosed in EP-A 522,616 wich therefor is incorporated herein by reference.

A particularly preferred photoinitiator for use in the present invention is a composition comprising a hexaarylbisimidazole, a tetraalkyldiaminobenzophenone e.g. Michler's ketone and a chain transfer agent (also called a hydrogen donor) e.g. 2-mercaptobenzoxazole as disclosed in EP-A 437,259.

According to the present invention thermal polymerization inhibitors may also be added to the photopolymerizable composition. Examples of inhibitors for use in accordance with the present invention are disclosed in EP-A 522,616 wich therefor is incorporated herein by reference.

According to a preferred mode of the present invention the hydrophobic photopolymerizable composition comprising at least one monomer and at least one polymeric binder comprises as polymeric binder a thermoplastic polymer. Suitable thermoplastic polymers for use in accordance with the present invention are disclosed e.g. in EP-A 522,616 which therefor is incorporated herein by reference.

To the hydrophobic photopolymerizable composition there can also be added non-thermoplastic polymeric compounds to give certain desirable characteristics, e.g. to improve adhesion to said hydrophilic base layer used in accordance with the present invention, wear properties, chemical inertness, etc. Suitable non-thermoplastic polymeric compounds include cellulose, phenolic resins and melamine-formaldehyde resins, etc. If desired, the photopolymerizable compositions can also contain immiscible polymeric or non-polymeric organic or inorganic fillers or reinforcing agents which are essentially transparent at the wave-lengths used for the exposure of the photopolymeric material, e.g. organophilic silicas, bentonites, silica, powdered glass, colloidal carbon, as well as various types of dyes and pigments in amounts varying with the desired properties of the photopolymerizable composition. The fillers are useful in improving the strength of the composition, reducing tack and in addition, as coloring agents.

Agents to improve the wetting and/or adjust the adhesion of the photopolymerisable composition may be added. Suitable agents are e.g. silicons, silicon containing polymers e.g. a poly(dimethylsiloxane)-polyether copolymer, poly(dimethylsiloxane)-polyester,silicon containing surfactants, fluor containing copolymers and fluor containing surfactants etc..

Various dyes, pigments, thermographic compounds, UV-absorbers, anti-oxidants and color forming components as disclosed in EP-A 522,616 can be added to the photopolymerizable compositions. These additive materials, however, preferably should not absorb excessive amounts of light at the exposure wavelength or inhibit the polymerization reaction.

The imaging element may comprise a temporary protective layer (packet) as topmost layer (packet) of the photopolymerizable composition, preferably a cellulose triacetate or polyethylene terephtalate film base coated with a hydrophilic release layer e.g. polyvinyl alcohol. Said temporary layer (packet) should be removed before or after the photo-exposure step but before the processing steps.

The imaging element may be prepared by laminating layers or packets of layers to each other or preferably by coating the layers on each other.

A receptor element according to the invention comprises at least one receptor layer which is capable of adhering to said hydrophobic photopolymerizable composition. Said receptor element is preferably stable at the processing conditions. The particular receptor element used is dependant on the nature of the composition of the imaging element.

In one embodiment, said receptor element comprises as the receptor layer paper or a poly-Alpha-olefin coated paper. In a preferred embodiment, said receptor layer is a commercially available paper brand as disclosed in PCT/EP 94/02063, which therefor is incorporated herein by reference or a polyethylene coated paper.

In another preferred embodiment, said receptor element comprises as the receptor layer an adhesive layer applied on a flexible support and adhering to said support.

Suitable flexible supports are paper; cardboard; metal foils and meshes e.g. aluminium, copper, steel, bronze etc.; transparent organic resin films e.g. of cellulose esters such as cellulose acetate, cellulose propionate and cellulose butyrate, polyvinyl acetals, polystyrene, polycarbonate or polyvinylchloride; opaque foamed or pigmented polyester; silk; cotton and viscose rayon fabrics or screens. Said receptor element may further comprise a thin additional layer. Examples of such receptor elements are supports provided with a thin metal layer e.g. polyester supports provided with a vapour deposited metal layer. Said receptor element may also comprise (a) additional layer(s) such as (a) backing layer(s) as described hereinbefore.

The adhesive layer is a thermo-adhesive layer or a pressure-adhesive layer.

Suitable thermo-adhesive layers (TALs) for use in the present invention have a glas transition temperature $T_g$ between 1O °C and 100 °C as measured with the 1090 THERMOANALYZER of Du Pont Co.. During the lamination step a minimal thermal load should be imposed to the material in order to save energy and diminish the risk for material change or deformation. For these reasons the $T_g$ of the TAL is preferably below 60 °C. The $T_g$ value of the TAL can be determined by the $T_g$ value of the polymer(s) used and/or by the addition of polymeric or low-molecular plasticizers or thermosolvents.

The adherance of the TAL to the imaging element is also determined by the flow properties of the TAL while heating above the $T_g$. A parameter for describing this property is the melt viscosity. A TAL suitable for use in accordance with the present invention has a melt viscosity of more than 3000 Poise measured at 120 °C with the VISCOELASTIC MELT TESTER of Rheometrics Co, Surrey, UK..

In order to induce easy film formation without unwanted sticking of the TAL to the backside of the receptor medium or to other materials a TAL is preferably used with a $T_g$ value between 20 °C and 45 °C, a melt viscosity greater than 7000 Poise and an elasticity corresponding to a tg $\delta^{-1}$ value greater than 1.30 measured at 120 °C with the VISCOELASTIC MELT TESTER of Rheometrics Co, Surrey, UK.. The tg $\delta^{-1}$ value is a measure for the elasticity as described in "Polymer Chemistry : the Basic Concept" by P.C. Hiemenz, 1984, edit. by M. Dekker Inc., New York.

For ecological and practical reasons the TAL is preferably coated from an aqueous medium. Therefore the polymers are preferably incorporated as latices.

Preferred latices are latices of styrene, styrene-butadiene, styrene-(meth)acrylate and n.butylacrylate-methylmethacrylate-acrylonitrile. These latices can contain other comonomers which improve the stablitity of the latex, such as acrylic acid, methacrylic acid and acrylamide. Other possible latices include polyvinylacetate, polyethylene-vinylacetate, polyacrylonitrile-butadiene-acrylic acid, polymethylmethacrylate-butylmethacrylate, polymethylmethacrylate-ethylacrylate, polystyrene-butylacrylate, polymethylmethacrylate-butadiene, polyester of terephtalic acid-sulphoisophtalic acid-ethyleneglycol, copolyester of terephtalic acid-sulphoisophtalic acid-hexanediol-ethyleneglycol.

Particularly suitable polymers for use in the TAL layer are the BAYSTAL polymer types, marketed by Bayer AG, Germany, which are on the basis of styrene-butadiene copolymers with a weight ratio between 40/60 and 80/20. If desired a few weight % (up to about 10 %) of acrylamide and/or acrylic acid can be included. Other useful polymers are the EUDERM polymers, also from Bayer AG, which are copolymers comprising n.-butylacrylate, methylmethacrylate, acrylonitrile and small amounts of methacrylic acid.

Various additives can be present in the TAL to improve the layer formation or the layer properties, e.g. thickening agents, surfactants, levelling agents, thermal solvents and pigments.

Apart from the thermo-adhesive layer to which the imaging element will be laminated and which must comply with the requirements described above the receptor element can contain one or more supplementary thermo-adhesive layer(s) positioned between the upper TAL and the hydrophobic photopolymerizable composition e.g. to optimize the adherance to the flexible support in view of obtaining a better image quality after the delamination process. This (these) other TAL(s) can have a composition and/or physical properties different from those imposed to the upper TAL. This (these) layer(s) can contain one polymer or a mixture of polymers, optionally in combination with low-molecular additives like plasticizers or thermosolvents. Other ingredients which can be incorporated include waxes, fillers, polymer beads, glass beads, silica etc..

Suitable pressure-adhesive layers (PALs) for use in the present invention comprise one or more pressure sensitive adhesives. Said pressure sensitive adhesives are preferably tacky elastomers e.g. block copolymers of styrene/isoprene, styrene/butadiene rubbers, butyl rubbers, polymers of isobutylene and silicones. Particularly preferred are natural rubbers and acrylate copolymers as disclosed in US-P 3,857,731. The used pressure sensitive adhesive preferably has a continuous-coat (100% coverage) peel adhesion value, when applied to untreated paper, between 1 and 10 N/cm width, more preferably between 2 and 7 N/cm width.

According to the present invention the pressure-adhesive layer Comprising a pressure sensitive adhesive may contain a binder. Suitable binders for use in combination with the pressure sensitive adhesives are binders that are inert towards the pressure sensitive adhesives i.e. they do not chemically attack the pressure sensitive adhesives or act as a solvent for them. Examples of such binders are nitrocellulose, urethanes, gelatin, polyvinyl alcohol etc...

The amount of binder should be chosen such that the pressure sensitive adhesives are effectively anchored to the hydrophobic photopolymerizable composition. Preferably the amount of binder is lower than 2.5 parts by weight with respect to the pressure sensitive adhesives and more preferably lower than 0.6.

According to the present invention the pressure-adhesive layer comprising a pressure sensitive adhesive may also contain a tackyfier e.g. rosin soap or a terpene.

The thickness of the adhesive layer is important for the adherence during the lamination/delamination process. Preferably the thickness of said adhesive layer lies between 0.1 and 30 $\mu$m, more preferably between 0.5 and 15 $\mu$m.

A receptor element comprising more than one layer may be prepared by coating the layers on each other or by laminating layers or packets of layers to each other.

According to the method of the present invention for obtaining an image an imaging element according to the present invention is image-wise or information-wise exposed to actinic radiation to harden the photopolymerizable composition pattern-wise. The exposure can be a contact exposure using e.g ultraviolet radiation, a camera exposure, a scanning exposure, or a laser exposure. The radiation source used in carrying out the exposure step includes e.g. sunlight, incandescent lamps, mercury vapour lamps, halogen lamps, xenon lamps, fluorescent lamps, light-emitting diodes, lasers, electron rays, and X-rays.

Subsequent to the image-wise or information-wise exposure an image is obtained by (i) laminating the hydrophobic photopolymerizable composition of said imaging element after said exposure and the removal of the temporary layer (packet), if present, to the receptor layer of a receptor element, said layer being capable of adhering to said hydrophobic photopolymerizable composition and (ii) peeling away the receptor element from the hydrophilic base thus transferring said hydrophobic photopolymerizable composition pattern-wise to the receptor element and uncovering the image comprised of the hydrophilic base and the retained hydrophobic photopolymerizable composition.

When the receptor layer of said receptor element is not a pressure-adhesive layer a heating step is required between the exposure and the peeling step, preferably at a temperature between 25 °C and 180 °C, more preferably at a temperature between 65 °C and 120 °C. Said heating may be applied to either or both the imaging element and the receptor element before, while or after bringing both in contact with each other. A higher temperature results in a higher sensitivy probably due to a better pattern-wise adherance of the receptor element to the imaging element.

When the receptor layer of said receptor element is a pressure-adhesive layer a pressure step is required between the exposure and the peeling step. Said pressure is applied while both the imaging element and the receptor element are in contact with each other, resulting in laminating both elements to each other.

An imaging element and a receptor element may be brought in contact before exposure. In such embodiment it is required that the back of either the imaging element and/or preferably the receptor element is transparent for the radiation used for the exposure of the photopolymerizable composition.

An overall exposure, before or after the image-wise exposure can be applied to the imaging element according to the present invention, resulting in a higher sensitivity.

It may be advantageous to overall expose the image to light and/or heat to enhance its stability. Such a procedure is especially preferred when the image is used as a printing master as described above, when the imaging element according to the present invention is positive working or to improve the scratch resistance of the image.

Because the imaging element according to the present invention comprises a hydrophobic photopolymerizable composition on a hydrophilic base, the obtained image can be used as a lithographic printing plate. Pattern-wise transfer of the photopolymerizable composition to a receptor material results in an image-wise differentiation between hydrophilic and hydrophobic parts that can be used to print with an oily or greasy ink. The hydrophobic parts will be capable of accepting lithographic ink, whereas the hydrophilic areas, when moistened with water, will not accept the ink. The areas which accept ink form the printing image areas and the ink-rejecting areas form the background areas.

The imaging element can be either positive working or negative working depending i.a. on the weight ratio in the hydrophobic photopolymerizable composition between monomer and (thermoplastic) polymer. For a negative working system said ratio is in general less than 1, preferably less than 0.5. For a positive working system said ratio is in general more than 1, preferably more than 2.

In a negative working imaging element according to the present invention the information-wise exposure to actinic radiation hardens the photopolymerizable composition pattern-wise in correspondence to the information-wise distribution of actinic radiation. Subsequent to the information-wise exposure the lithographic printing plate is obtained by (i) laminating the hydrophobic photopolymerizable composition of said imaging element after said exposure and the removal of the temporary layer (packet), if present, to the receptor layer of a receptor element, said layer being capable of adhering to said hydrophobic photopolymerizable composition-and (ii) peeling away the receptor element from the hydrophilic base, thereby transferring the non-hardened or insufficiently hardened parts of the hydrophobic photopolymerizable composition to the receptor element and uncovering the lithographic printing plate comprised of the hydrophilic base and the retained hardened parts of the hydrophobic photopolymerizable composition.

In a positive working imaging element according to the present invention the information-wise exposure to actinic radiation hardens the photopolymerizable composition pattern-wise in correspondence to the information-wise distribution of actinic radiation. Subsequent to the information-wise exposure the lithographic printing plate is obtained by (i) laminating the hydrophobic photopolymerizable composition of said imaging element after said exposure and the removal of the temporary layer (packet), if present, to the receptor layer of a receptor element, said layer being capable of adhering to said hydrophobic photopolymerizable composition and (ii) peeling away the receptor element from the hydrophilic base, thereby transferring the hardened parts of the hydrophobic photopolymerizable composition to the receptor element and uncovering the lithographic printing plate comprised of the hydrophilic base and the retained unhardened parts of the hydrophobic photopolymerizable composition.

The following example illustrates the present invention without limiting it thereto. All percentages are by weight unless stated otherwise.

EXAMPLE 1

Preparation of a hydrophilic base

To 440 g of a dispersion contg. 21.5% of $TiO_2$ (average particle size 0.3 to 0.5 $\mu$m) and 2.5% of polyvinyl alcohol in deionized water were subsequently added, while stirring, 250 g of a 5% polyvinyl alcohol solution in water, 105 g of a hydrolyzed 22% tetramethylorthosilicate emulsion in water and 12 g of a 10% solution of a wetting agent.
To this mixture was added 193 g of deionised water and the pH was adjusted to pH = 4.
The obtained dispersion was coated on a polyethylene-terephthalate film support having a thickness of 175$\mu$m (having provided thereon a hydrophilic adhesion layer) to a wet coating thickness of 50 g/m$^2$, dried at 30 °C. and subsequently hardened by subjecting it to a temperature of 57 °C for 1 week.

Preparation of the imaging element

An imaging element was prepared as follows. The hydrophilic base was coated by means of a knife coater with a photosensitive composition consisting of a solution in methylethyl ketone of 1.5 % by weight of dipentaerythritol pentaacrylate, 6.85 % by weight of a copolymer of styrene/butylmethacrylate, 0.15% by weight of a blue dye (C.I. 61551), 1.33 % by weight of bis-imidazole, 0.1% by weight of Michler's ketone, and 0.07% by weight of mercaptobenzoxazole. The mixture was coated to a wet coating thickness of 25 $\mu$m.
On top of the imaging element described above there was placed a test target with a 60 lines per cm screen as well as fine positive and negative lines, and the imaging element was exposed therethrough to ultraviolet radiation.
The exposed imaging element was then placed in face-to-face contact with a paper receptor element (Ideal Blanc Brillant-170 g/m$^2$, marketed by Papeterie Belge, S.A., Belgium).
The contacting elements were conveyed through a roll laminator device at 107 °C and at a speed of 0.3 m/min. Next, the elements were peeled apart whereby the non-exposed parts of the photopolymerizable composition are removed and the exposed areas remain on the hydrophilic base thus being a negative working system.
The sample showed a line reproduction for lines of 20 $\mu$m.
The obtained lithographic printing plate was used on a conventional offset press using a commonly employed ink and fountain to print > 15,000 copies of good quality.

## Claims

1.  A method for obtaining a lithographic printing plate comprising the steps of:
    (a) image-wise or information-wise exposing an imaging element comprising on a hydrophilic base a hydrophobic photopolymerizable composition capable of being irradiated with actinic light through the support and/or through the front and comprising at least one monomer and at least one polymeric binder , said photopolymerizable composition comprising the top layer of said imaging element or the layer contiguous to a temporary protective layer (packet) being the top layer (packet) of said imaging element,
    (b) laminating the hydrophobic photopolymerizable composition of said imaging element after said exposure and the removal of the temporary layer (packet), if present, to the receptor layer of a receptor element, said receptor layer being capable of adhering to said hydrophobic photopolymerizable composition and being a pressure-adhesive layer, a thermoadhesive layer, having a glas transition temperature $T_g$ between 1O °C and 100 °C as measured with the 1090 THERMOANALYZER of Du Pont Co. and a melt viscosity of more than 3000 Poise measured at 120 °C with the VISCOELASTIC MELT TESTER of Rheometrics Co, Surrey, UK. or paper or a poly-Alpha-olefin coated paper.
    (c) peeling away the receptor element from the hydrophilic base thus transferring said hydrophobic photopolymerizable composition pattern-wise to the receptor element.

2. A method for obtaining a lithographic printing plate according to claim 1 wherein said hydrophilic base is a hydrophilic base comprising on a flexible hydrophilic support a hardened hydrophilic layer containing (i) polyvinyl alcohol hardened with hydrolyzed tetraalkyl orthosilicate wherein the weight ratio between said polyvinylalcohol and said tetraalkyl orthosilicate is between 0.1 and 5 and (ii) siliciumoxide and/or titaniumdioxide.

3. An imaging element according to claim 2 wherein said hydrophobic photopolymerizable composition is contiguous to said hydrophilic base.

4. A method for obtaining a lithographic printing plate according to claim 1 wherein said hydrophilic base is a grained, anodized and optionally sealed aluminum foil.

5. A method for obtaining a lithographic printing plate according to any of claims 1 to 4 wherein said monomer contains at least two polymerizable ethylenically unsaturated groups.

6. A method for obtaining a lithographic printing plate according to any of claims 1 to 5 wherein the weight ratio in the hydrophobic photopolymerizable composition between said monomer(s) and said polymer(s) is less than 0.5 so as to form a negative working plate.

7. A method for obtaining a lithographic printing plate according to any of claims 1 to 5 wherein the weight ratio in the hydrophobic photopolymerizable composition between said monomer(s) and said polymer(s) is more than 2 so as to form a positive working plate.

8. A method for obtaining a lithographic printing plate according to any of claims 1 to 6 wherein said receptor element comprises on a flexible support a thermo-adhesive layer having a glas transition temperature $T_g$ value between 20 °C and 45 °C, measured with the 1090 THERMOANALYZER of Du Pont Co., a melt viscosity greater than 7000 Poise and an elasticity corresponding to a tg $\delta^{-1}$ value greater than 1.30 measured at 120 °C with the VISCOELASTIC MELT TESTER of Rheometrics Co, Surrey, UK.

9. A method for obtaining a lithographic printing plate according to any of claims 1 to 8 wherein heating at a temperature between 40 °C and 180 °C is applied to either or both the imaging element and the receptor element after removal of the temporary layer (packet), if present, before, while or after bringing both elements in contact with each other.

10. A method for obtaining a lithographic printing plate according to any of claims 1 to 6 wherein said receptor element comprises on a flexible support a pressure-adhesive layer with a continuous-coat (100% coverage) peel adhesion value, when applied to untreated paper between 1 and 10 N/cm width.

11. A method for obtaining a lithographic printing plate according to claim 10 wherein pressure is applied to both the imaging element and the receptor element while both elements are in contact with each other.

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| D,X | GB-A-1 530 410 (FUJI PHOTO FILM CO., LTD.,) | 1-11 | G03F7/34 |
| Y | * line 61 - line 80; claims * | 2,6 | G03F7/11 |
| Y | * page 4, line 52 - line 107 *<br>* page 5, line 35 - line 46 *<br>* page 7, line 41 - line 48; claims *<br>--- | 1 | |
| Y | US-A-4 925 767 (E.R. DEAMS et Al.)<br>* column 5, line 16 - line 18 *<br>--- | 1 | |
| Y | EP-A-0 465 087 (HOECHST CELANESE CORPORATION)<br>* page 5, line 38 - page 6, line 1 *<br>--- | 1 | |
| D,X | EP-A-0 568 744 (HOECHST CELANESE CORPORATION)<br>* the whole document *<br>--- | 1-11 | |
| D,X | US-A-3 342 593 (M. BURG)<br>* column 7, line 62 - line 72; claims; figure X *<br>--- | 1,3-5,9 | TECHNICAL FIELDS SEARCHED (Int.Cl.6) |
| D,X | US-A-3 307 943 (R.B. HEIART)<br>* column 10, line 67 - column 11, line 2 *<br>--- | 1 | G03F |
| D,Y | EP-A-0 450 199 (AGFA-GEVAERT N.V.)<br>* the whole document *<br>--- | 2 | |
| D,Y | EP-A-0 040 424 (E.I. DU PONT DE NEMOURS AND COMPANY)<br>* the whole document *<br>--- | 6 | |
| A | PATENT ABSTRACTS OF JAPAN<br>vol. 9, no. 90 (P-350) (1813) 19 April 1985<br>& JP-A-59 218 446 (MITA KOGYO K.K) 8 December 1984<br>* abstract * | 5,6 | |

The present search report has been drawn up for all claims

| Place of search | Date of completion of the search | Examiner |
|---|---|---|
| THE HAGUE | 28 February 1995 | Rasschaert, A |

EPO FORM 1503 03.82 (P04C01)